## Europäisches Patentamt

## European Patent Office

## Office européen des brevets

(19)

(11) Veröffentlichungsnummer: **0 027 565**
**B1**

(12) # EUROPÄISCHE PATENTSCHRIFT

(45) Veröffentlichungstag der Patentschrift:
02.04.86

(21) Anmeldenummer: 80105790.2

(22) Anmeldetag: 25.09.80

(51) Int. Cl.⁴: **G 11 C 11/24, H 01 L 27/10,**
**H 01 L 21/76**

(54) **Dynamische Speicherzelle mit zwei komplementären bipolaren Transistoren.**

(30) Priorität: 22.10.79 US 87596

(43) Veröffentlichungstag der Anmeldung:
29.04.81 Patentblatt 81/17

(45) Bekanntmachung des Hinweises auf die Patenterteilung:
02.04.86 Patentblatt 86/14

(84) Benannte Vertragsstaaten:
DE FR GB IT NL SE

(56) Entgegenhaltungen:
EP - A - 0 002 670
EP - A - 0 003 030

IBM TECHNICAL DISCLOSURE BULLETIN, Band 21, Nr. 3, August 1978, Seiten 1004-1006, New York, USA, C.G. JAMBOTKAR: "Realization of large-value capacitance across base and collector terminals of a bipolar transistor"

(73) Patentinhaber: **International Business Machines Corporation, Old Orchard Road, Armonk, N.Y. 10504 (US)**

(72) Erfinder: **El-Kareh, Badih, RFD Nr. 2 Westford Road, Milton Vermont 05468 (US)**

(74) Vertreter: **Rudolph, Wolfgang, Dipl.-Ing., Schönaicher Strasse 220, D-7030 Böblingen (DE)**

**Beschreibung**

Die Erfindung betrifft eine dynamisch betriebene Speicherzelle mit bipolaren Transistoren für einen hochintegrierten Speicher, dessen Speicherzellen über Wort- und Bitleitungen ansteuerbar sind.

Dynamisch betriebene Speicherzellen aus bipolaren Transistoren sind prinzipiell bekannt. So ist z.B. eine Speicherzelle aus der DE-A1-zu 155 228 bekannt, die aus zwei komplementären, nach Art einer Vierschicht-Zelle, jeweils zwischen Basis und Kollektor verbundenen Transistoren besteht, die dynamisch betrieben wird. Diese Speicherzelle ist dadurch charakterisiert, dass der eine gemeinsame Basis-Kollektoranschluss an eine erste Ansteuerleitung angeschlossen ist, über die ein Kippvorgang unterdrückt wird, und dass die beiden Emitteranschlüsse mit zugeordneten zweiten und dritten Ansteuerleitungen verbunden sind, über die der Speichervorgang als Auf- und Entladung der Basis-Kollektorkapazität der Transistoren erfolgt. Das Auslesen erfolgt über eine dritte Ansteuerleitung durch Anheben des Potentials auf der ersten Ansteuerleitung, wobei der erste Transistor in Abhängigkeit vom Ladezustand der Basis-Kollektorkapazität leitend oder gesperrt ist, was einer gespeicherten 0 bzw. 1 entspricht, je nach Zuordnung.

Ausserdem ist durch die prioritätsgleiche DE-A-2 156 805 eine weitere dynamische Speicherzelle bekannt geworden, die zwar hinsichtlich der Schaltung der Speicherzelle und der Betriebsweise im wesentlichen mit der bereits beschriebenen übereinstimmt, sich jedoch in der monolithischen Struktur unterscheidet. Bei dieser Speicherzelle ist das erste Halbleiterbauelement ein PNP-Transistor, an dessen Emitter die Schreibleitung angeschlossen ist, dessen Kollektor mit der Basis des als Ausgangstransistor dienenden zweiten Halbleiterelements vom NPN-Typ verbunden ist und dessen Basis sowohl an den Kollektor des NPN-Ausgangstransistors als auch eine gemeinsame Lese- und Datenleitung angeschlossen ist, und bei denen die parasitäre Kapazität zwischen Verbindung des Kollektors des Eingangstransistors mit der Steuerelektrode des Ausgangstransistors und der Verbindung des Kollektors des Ausgangstransistors mit der Steuerelektrode des Eingangstransistors liegt.

Obwohl sich beide Speicherzellen durch einen geringen Platzbedarf auszeichnen und auch sehr schnelle Schaltzeiten erreicht werden, haben sie jedoch den Hauptnachteil, dass sie durch die Verwendung der Basis-Kollektorverbindung sowohl des PNP- als auch des NPN-Transistors eine sehr kleine Kapazität zur Informationsspeicherung aufweisen. Dies wiederum bedingt, dass das Ausgangssignal in seiner Amplitude äusserst klein ist, so dass der Abstand zwischen dem 1- und dem 0-Signal mit relativ hohem technischen Aufwand in den peripheren Schaltkreisen unterschieden werden muss. Eine erhöhte Steueranfälligkeit ist die Folge. In der europäischen Patentanmeldung EP-A2-0 003 030 ist deshalb eine weitere dynamische bipolarische Speicherzelle bekannt geworden, die ein höheres Ausgangssignal beim Lesen sowie einen grösseren Abstand zwischen dem 0- und dem 1-Signal ermöglicht. Dies wird dadurch erreicht, dass die zur eigentlichen Speicherung der Information benützte Kapazität vergrössert wird, ohne dass der Platzbedarf in der monolithischen Struktur der Speicherzelle vergrössert wird und ohne dass das sonstige Verhalten der Speicherzelle nachteilig beeinflusst wird.

Die Lösung gemäss dieser genannten europäischen Patentanmeldung besteht darin, dass der Speicher- oder Ladungspunkt zwischen der Basis des Lesetransistors und dem Kollektor des Schreibtransistors ist, dass der Speicherpunkt mit einer ersten und der zweiten Kapazität und weiterhin mit einer dritten Kapazität verbunden ist, die ausserdem mit einem festen Potential verbunden ist, und dass ein Punkt der Verbindungsleitung zwischen Kollektor des Lesetransistors und Basis des Schreibtransistors über die Bitleitung mit einem kombinierten Abfühlverstärker/Bittreiber verbunden ist, dass der Emitter des Schreibtransistors mit einem Schreibtreiber verbunden ist und dass ein Punkt der Verbindungsleitung zwischen Emitter des Lesetransistors und dem ersten Kondensator mit einem Lesetreiber verbunden ist. Die Kapazitäten werden dabei als Verarmungskapazitäten zwischen gleichzeitig diffundierten P-Regionen und einer diffundierten epitaxialen Insel vom N-Typ hergestellt. Diese epitaxiale Insel ist dabei innerhalb der Epitaxischicht, oberhalb der Subkollektorregion und unterhalb zweier P-Typ-Regionen angeordnet und in einer der P-Regionen liegt weiterhin eine N-Diffusion, die durch ein Fenster in einer Schicht aus Siliciumdioxid während der Herstellung eingebracht wird.

Diese Speicherzelle hat den Nachteil, dass das Verfahren zum Herstellen äusserst kompliziert ist, so dass die Ausschussquote sehr hoch liegt und nicht weiter heruntergedrückt werden kann. Ausserdem ist die so hergestellte Kapazität immer noch in einem Bereich, der hinsichtlich der Auswirkung auf das Ausgangssignal und auf das Verhältnis der Störsignale nachteilig ist. Eine Vergrösserung der Kapazität ist aber aufgrund des komplizierten Herstellungsverfahrens und der erforderlichen Struktur für diese Speicherzelle nicht möglich.

Ausserdem ist aus dem IBM Technical Disclosure Bulletin Vol. 21, Nr. 3, August 1978, Seiten 1004 bis 1006 die Vergrösserung der Basiskollektorkapazität von bipolaren Transistoren bekannt, in dem die Basis von tiefen Gräben umgeben wird, und zwar je nach gewünschter Grösse der Kapazität nur an einer Seite, an mehreren Seiten oder an allen vier Seiten. Obwohl hier prinzipiell der Weg gezeigt ist, durch vertiefte Gräben direkt um das Basisgebiet herum die Basiskollektorkapazität zu vergrössern, führt die Anwendung dieser Lösung auf die vorhergenannte Speicherzelle der EP-A2-0 003 030 nicht zu dem gewünschten Ergebnis, da die Einfügung der Gräben rings um die Basis den Flächenbedarf der Speicherzelle auf dem Substrat wesentlich vergrössern würde und ausserdem die Herstellung zusätzlich erschweren würde, da derartig kleine Gräben äusserst schwierig herzustellen sind. Ausserdem fehlt eine gewünschte Isolierung der einzelnen Speicherzelle gegenüber den benachbarten Zellen, um gegenseitige Störungen zu vermeiden. Hinzu kommt noch, dass die Speicherzelle drei unterschiedliche Kapazitäten aufweist, und zwar die erste zwischen dem Emitter und der Basis des PNP Transistors, die zweite zwischen der Basis und dem Kollektor des NPN Transistors und die dritte Kapazität durch die kombinierte Kapazität der PN-Übergangskapazität. Die Kombination der Lösungen der beiden letztgenannten Veröffentlichungen bringt demnach keine Lösung hervor, die sich für ein Speicherzellenarray eignen würde.

Der Erfindung liegt deshalb die Aufgabe zugrunde, eine verbesserte dynamisch betriebene Speicherzelle mit bipolaren Transistoren zu schaffen, die sich durch eine vergrösserte Kapazität zur Informationsspeicherung auszeichnet, so dass das Verhältnis Störsignal zu Nutzsignal wesentlich verbessert wird, die ausserdem eine höhere Integrierbarkeit und eine wesentliche Vereinfachung des Herstellungsverfahrens erlaubt.

Die erfindungsgemässe dynamisch betriebene Speicherzelle mit bipolaren Transistoren ist im Kennzeichen des Patentanspruchs 1 charakterisiert.

Weitere Merkmale der Speicherzelle sind in den Patentansprüchen 2 bis 6 angegeben.

Der Vorteil dieser dynamischen Speicherzelle besteht vor allem darin, dass die Prozessschritte des Herstellungsverfahrens sich wesentlich vereinfachen und dass trotz wesentlicher Erhöhung der zur Informationsspeicherung erforderlichen Kapazität die Speicherzelle auf Toleranzen im Herstellungsverfahren selbst und in der Struktur, Grösse und Stärke sowie in der Zusammensetzung der verwendeten Materialien wenig empfindlich ist. Dies führt zu einer wesentlichen Verringerung der Ausschussrate bei einer Verbesserung des Leistungsvermögens der Speicherzelle.

Die Erfindung wird nun anhand von in den Zeichnungen dargestellten Ausführungsbeispielen näher beschrieben.

In der Zeichnung bedeuten:

Fig. 1 eine Draufsicht auf einen Ausschnitt einer Speicher-Anordnung;

Fig. 2 einen vertikalen Schnitt durch die Anordnung gemäss Fig. 1;

Fig. 3 ein Prinzipschaltbild der dynamisch betriebenen Speicherzelle mit bipolaren komplementären Transistoren sowie den erforderlichen peripheren Schaltkreisen und

Fign. 4 bis 9 wichtige Schritte während des Herstellungsverfahrens.

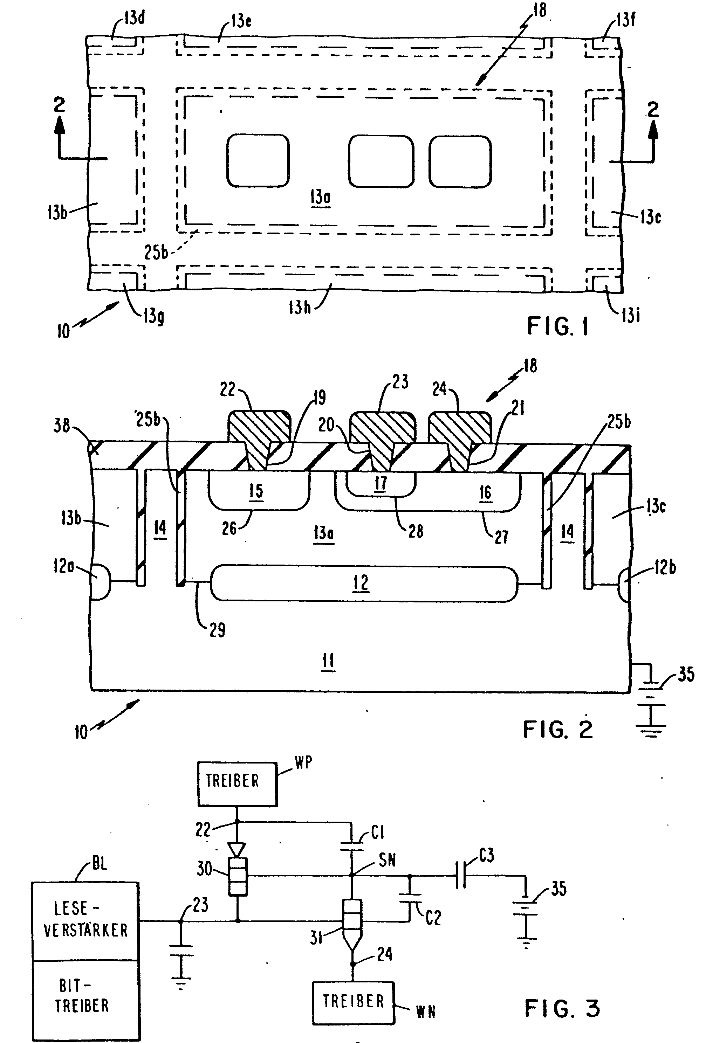

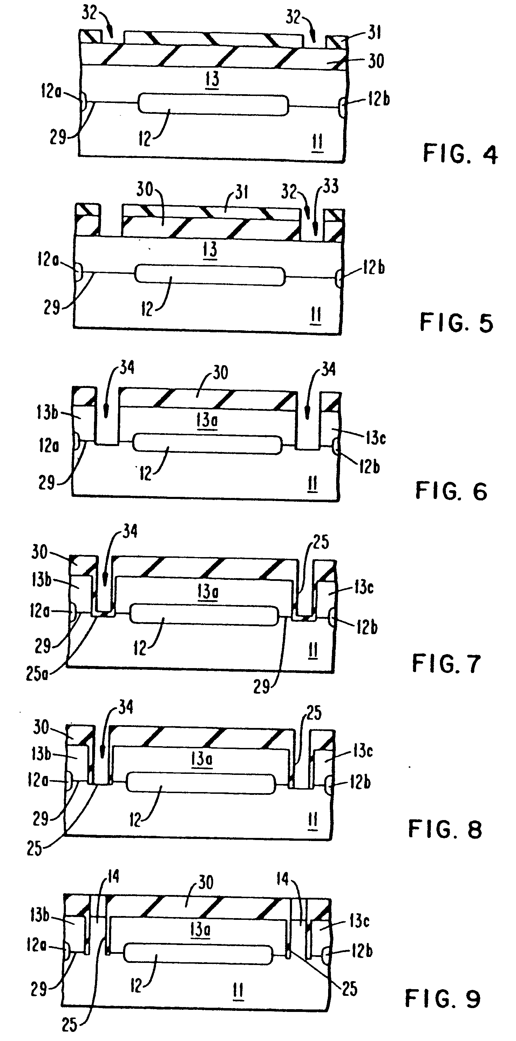

In Fig. 1 ist ein Ausschnitt aus einem Halbleiterspeicherchip 10 zu sehen, das mehrere 10 000 Zellen umfasst, wovon jedoch nur eine Zelle 18 in der Fig. 1 komplett zu sehen ist. Wie aus Fig. 4 zu sehen ist, ist ein Substrat 11 aus einem Halbleitermaterial, insbesondere P-Silicium, mit Hilfe bekannter Diffusionstechniken so ausgebildet, dass darin eine Vielzahl von N+-Subkollektoren 12, 12a und 12b liegen. Nach der Bildung der Subkollektoren wird eine N-Epitaxialschicht 13 auf das Substrat 11 aufgebracht. Während der Bildung dieser Epitaxialschicht diffundieren die Subkollektoren in die Epitaxialschicht, wie aus den Figuren zu ersehen ist. Dadurch entsteht zwischen dem Substrat 11 und der Epitaxialschicht 13 und den Subkollektoren ein PN-Übergang 29; wenn die Epitaxialschicht 13 bis zur erforderlichen Dicke, die gewöhnlich bei 5 µ liegt, aufgewachsen ist, wird dieses Bauteil so weiterbearbeitet, wie es in den nachfolgenden Schritten angegeben ist, um ein Isolationsgitter zu schaffen, das jede einzelne Zelle 18 einschliesst. Dieses Isolationsgitter wird durch Schneiden eines Grabens bzw. einer Kerbe oder Rinne durch die Epitaxialschicht 13 hergestellt.

Danach werden die Wände dieses so geschaffenen Grabens mit einer dünnen Oxidschicht überzogen und mit Silicium wieder aufgefüllt. Das so hergestellte Isolationsgitter durchdringt, wie vorher angegeben, die Epitaxialschicht, so dass das eingefüllte Silicium mit dem P-Substrat verschmilzt. Ein solch gebildetes Isolationsgitter umschliesst jede hergestellte Subkollektorregion komplett und definiert Inseln, in denen die Epitaxialschicht jede Subkollektorregion überlappt. In dem Fall, wo nur ein einziger Subkollektor vorhanden ist, muss der Graben durch den Subkollektor in das Substrat 11 hinein geschnitten werden.

Wenn die Epitaxialschichtregion 13 voll aufgewachsen ist, wird es mit einem dicken Oxid 30, welches seinerseits mit einer Photolackschicht 31 überzogen ist, beschichtet. Die Oxidschicht 30 muss ungefähr 20% dünner sein als die Epitaxialschicht 13. Wie aus Fig. 5 zu ersehen ist, wird dann danach die Photolackschicht 31 mit bekannten photolithographischen Verfahren belichtet und entwickelt, um Öffnungen 32 in der Photolackschicht 31 zu bilden. Diese Öffnungen 32 werden mit einem gitterähnlichen Muster in die Photolackschicht 31 eingebracht, und zwar in der Form wie dann die Endstruktur des Isolationsgitters, das in der Epitaxialschicht 13 zu formen ist, aussieht. Durch bekanntes Ätzen wird durch die Öffnungen 32 in der Photolackschicht 31 ein Fenster 33 in der Oxidschicht 30 gebildet.

Wenn das Fenster 33 in der Oxidschicht 30 fertig ist, wird die Photolackschicht 31 entfernt und die gesamte Halbleitereinheit in eine reaktive Ionenätzkammer eingebracht. Ein Ionenätzprozess enthält das Einbringen von reaktivem Material, wie z.B. Salzsäure, bei einer Temperatur von ungefähr 200 °C in Dampfform in die Kammer mit der zu ätzenden Halbleitereinheit. Dieser Dampf ist ionisiert, so dass die reaktiven Ionen des reaktiven Materials gebildet werden. Diese Ionen werden direkt gegen die Oberfläche der Halbleitereinheit gerichtet, die zu ätzen ist. Dadurch wird, wie in Fig. 6 dargestellt ist, ein gerader mit vertikalen Wänden versehener Graben 34 in die Epitaxialschicht 13 unterhalb des Oxidfensters 33 geschnitten.

Nach Beendigung dieses Schrittes ist somit das gewünschte Isolationsgitter 14 in der Halbleitereinheit hergestellt, und zwar als ein einziger offener untereinander verbundener Graben 34. Um eine komplette Isolation einer jeden Speicherzelle sicherzustellen, ist es erforderlich, dass der Graben 34 komplett durch die Epitaxialschicht 13 und die PN-Grenzschicht 29 hindurchgeschnitten wird. Dadurch werden die total voneinander isolierten Inseln 13a bis 13i von epitaxialem Material, wie in den Fign. 1 und 6 dargestellt ist, gebildet.

Nach Abschluss dieses Prozesses wird die Halbleitereinheit in eine Oxidationskammer gebracht und einem Oxidationsprozess unterzogen. Dies wird mit Hilfe eines Trägergases und 5%igem trockenem Sauerstoff ausgeführt, wobei das Trägergas bekannterweise Stickstoff oder Argon sein kann. Danach wird die gesamte Einheit auf ungefähr 1100 °C erhitzt und so lange in der Kammer bei dieser Temperatur gehalten, bis die senkrecht verlaufenden Wände und der Boden des Grabens 34 mit einer dünnen Siliciumdioxidschicht 25, wie in Fig. 5 zu sehen ist, überzogen ist und zwar mit einer Dicke von ca. 200 bis 500 Å. Nach der Bildung der thermischen Oxidationsschicht 25 wird die gesamte Einheit wieder in eine reaktive Ionenkammer eingebracht und zwar zum Zwecke der Entfernung des Oxidüberzugs 25a auf den Boden des Grabens 34. Dadurch wird die Oxidschicht 25 auf den senkrecht verlaufenden Wänden einer jeden vorhandenen Insel von den Wänden aller anderen Inseln, wie aus den Fign. 1 und 8 hervorgeht, getrennt.

Es soll hier bemerkt werden, dass durch diesen reaktiven Ionenätzprozess sich die Dicke der Oxidschicht 30 um einen Wert vermindert, der gleich der Dicke der Oxidschicht 25a ist, die vom Boden des Grabens 34 entfernt wurde.

Die Dicke der Oxidschicht 25 auf den senkrecht verlaufenden Wänden der Gräben wird dabei jedoch nicht signifikant verringert. Durch die Anwendung des bekannten chemischen Gasniederschlagverfahrens, bei dem das Gas mit einem Dopingmaterial, wie Boron, gemischt ist, kann das Siliciumgitter 14 in den Graben 34, wie aus Fig. 9 hervorgeht, P-gedopt werden. Dieses Siliciummaterial 14, welches sowohl polykristallines als auch Ein-Kristallmaterial sein kann, verschmilzt mit dem Substrat 11, weil die Oxidschicht 25a entfernt ist und bildet somit eine gute elektrische Verbindung mit dem Substrat 11. Das Füllsiliciummaterial 14 in dem Gitter bildet zwar eine sehr gute elektrische Verbindung mit dem Substrat 11, bleibt jedoch isoliert durch die Oxidschicht 25 an den senkrecht verlaufenden Wänden des Grabens 34 von jeder gebildeten Insel 13a bis 13i.

Wie aus Fig. 2 zu ersehen ist, werden nachfolgend die zwei P-Regionen 15 und 16 mit Hilfe bekannter Diffusionstechniken im oberen Teil der epitaxialen Insel 13a gebildet. Die Region 15 bildet einen PN-Übergang 26 mit der darunterliegenden epitaxialen Insel 13a, und die Region 16 bildet ebenfalls mit dieser epitaxialen Insel 13a einen PN-Übergang 27. Danach wird eine N-Diffusion 17 in die P-Diffusion 16 eingebracht, wodurch ein PN-Übergang 28 geschaffen wird. Nachdem diese Diffusionen eingebracht worden sind, wird das gesamte Halbleiterplättchen mit einer Schicht 38 von z.B. Siliciumdioxid mit einer Schichtdicke von 3000 Å überzogen. Durch diese so eben aufgebrachte Schicht 38 werden drei verschiedene Fenster oder Durchgangslöcher 19 bis 21 oberhalb der entsprechenden Diffusionen 15 bis 17 eingebracht. In diese Löcher werden dann Metallkontakte 22 bis 24 eingebracht, z.B. aus Aluminium, um die darunterliegenden Regionen 15 bis 17 zu kontaktieren. Dadurch wird in jeder Insel eine einzelne integrierte PNP-NPN-Transistorzelle 18, wie sie in Fig. 3 im Schaltbild dargestellt ist, gebildet.

Der in diesem Schaltbild angegebene PNP-Transistor 30 besteht aus der Region 15, welche als Emitter wirkt, aus der Region 16, welche als Kollektor wirkt, und dem Teil der nicht diffundierten Insel 13a als Basis, der dazwischenliegt.

Der NPN-Transistor 31 wird durch die Region 17, die als Emitter dient, durch die Region 16, welche als Basis dient, und durch die Region 13a, die zusammen mit dem Subkollektor 12 als Kollektor dient, gebildet.

Wie aus Fig. 3 zu ersehen ist, wird die Zelle von einem Treiber WP an der Kontaktstelle 22 getrieben, die gleichzeitig als Leseleitungskontakt dient. Ausserdem ist über den Kontakt 24, der als Schreibleitungskontakt dient, ein zweiter Treiberschaltkreis WN an die Zelle angeschlossen. Die Schaltung dieser Treiber wird nicht näher beschrieben, da diese hinlänglich bekannt sind.

Der PNP-Transistor 30 in Fig. 3 wirkt dabei als Lesetransistor und der NPN-Transistor 31 als Schreibtransistor. Über den Kontakt 23, der als Bitleitungskontakt dient, ist ausserdem an die Zelle ein bekannter Lese-Bittreiber BL angeschlossen.

Die Kapazität C1, die zwischen dem Emitter und der Basis des PNP-Transistors 30 liegt, ist als Kapazität des PN-Übergangs 26 in Fig. 2 dargestellt. Die Kapazität C2 zwischen der Basis und dem Kollektor des NPN-Transistors 31 ist durch die Kapazität der PN-Übergangs 27 dargestellt. Die Kapazität C3, die die kombinierte Kapazität der PN-Übergangskapazität 29 und des Oxidüberzugs 25b darstellt, welcher die Insel 13a vom Siliciumgitter 14 isoliert, ist in Fig. 3 ebenfalls dargestellt. Dabei stellt die Insel 13a eine Platte der Kapazität C3 dar, und zwar die, die mit der Basis des PNP-Transistors 30 verbunden ist. Das Substrat 11 und das Siliciumgitter 14 dienen als die andere Platte der Kapazität C3. Diese Platte ist mit einem festen Potential verbunden, wie es in Fig. 3 durch die Batterie 35 dargestellt ist. Jede der Kapazitäten C1 bis C3 hat dabei einen gemeinsamen Referenzpunkt, z.B. die genau definierte Epitaxialinsel 13a.

In der vorliegenden Zelle ist die Region 13a diejenige, in der die Information gespeichert wird.

Die Kapazitäten C1 und C2 sind beide sehr klein im Verhältnis zur Kapazität C3. Die Kapazität C3 ist wesentlich grösser als die Kapazität C1 und die Kapazitäten C1 und C2 haben die gleichen Charakteristiken, da beide als Verarmungskapazitäten zwischen den gleichzeitig diffundierten P-Regionen 15 und 16 und der definierten epitaxialen Insel 13a ausgebildet sind.

Die Region 13a in der nun die tatsächliche Speicherung erfolgt, ist schematisch in Fig. 3 durch den Punkt SN dargestellt, der für alle drei Kapazitäten C1 bis C3 gemeinsam ist. Durch Hinzufügen der Oxidschicht 25b ist die Kapazität C3 wesentlich vergrössert worden, woraus sich grosse Vorteile für den Betrieb der Speicherzelle nach Fig. 3 ergeben. Zum einen wird dadurch das Stör-/Nutzverhältnis zwischen dem 0- und dem 1-Signal wesentlich erhöht, ausserdem wird das Signal selbst während des Lesens nicht nachteilig beeinflusst und der Einfluss der Kapazität C1 wird ebenfalls bedeutend verringert.

Da die Leseoperation bei dieser in Fig. 3 dargestellten Zelle zerstörend ist, muss die gelesene Information nach Beendigung der Leseoperation wieder in die Zelle eingeschrieben werden.

Zur Illustration wird im vorliegenden angenommen, dass der Punkt SN auf 0,9 Volt liegt, das ist die Spannung, bei der der Speicherpunkt effektiv entladen ist. Da das Lesen zerstörend ist und zum anderen aber sichergestellt sein muss, dass sich die Zelle vor dem Einschreiben in einem bekannten Zustand befinden muss, wird immer erst eine Leseoperation durchgeführt.

Während der Leseoperation wird der Treiberschaltkreis WP am Punkt 22 und am Emitter des PNP-Transistors 30 von 0 auf 4 Volt angehoben. Gleichzeitig hält der Treiber WN die Spannung bei 1,3 Volt. Dadurch wird der PNP-Transistor 30 eingeschaltet und es fliesst Ladung über den PNP-Emitterbasis-Übergang, wodurch der Speicherpunkt SN aufgeladen wird und zwar von seinem ungeladenen Zustand bei 0,9 Volt auf seinen geladenen Zustand bei 3,2 Volt. Da der Leseimpuls bei 4 Volt bleibt, nachdem der Speicherpunkt SN 3,2 Volt erreicht, verbleibt der Transistor 30 eingeschaltet und Ladung fliesst somit über den Kollektor des PNP-Transistors 30, um die Bitleitung von 1,1 Volt nach 1,2 Volt anzuheben. Diese Spannungsänderung auf der Bitleitung wird durch den Bitleseverstärker BL abgefüllt und registriert. Da die Ladung, die über den Emitter-Basis-Übergang des PNP-Transistors fliesst, gleich dem Beta des PNP-Transistors ist, wird die zu seiner Basis geführte Ladung wesentlich verstärkt, wodurch die Zelle selbst erheblich kleiner ausgeführt werden kann. Diese Betaverstärkung bewirkt, dass trotz der Kleinheit der Zelle ein praktikabler Signallevel erreicht wird. Es soll noch erwähnt sein, dass die Leseperiode dadurch begrenzt wird, dass der Treiberschaltkreis WP zurück nach 0 Volt gebracht werden muss. Die Schreiben-Eins-Operation wird durch Halten des Schaltkreises WP auf 0 Volt und Setzen der Bitleitung auf 0,8 Volt durch den Bittreiber sowie Herabziehen des Schaltkreises WN von 1,3 auf 0,1 Volt erreicht, wodurch der Transistor 30 leitend wird und der Speicherpunkt SN auf 0,9 Volt entladen wird. Wenn das Signal des Schreibtreibers WN auf 1,3 Volt zurückgeht, wird die Bitleitungsspannung durch den Bittreiber BL auf 1,1 Volt gesetzt. Durch Entladung des Speicherpunkts ist damit eine «Eins» in diese Zelle eingeschrieben worden. Es wird nun angenommen, dass diese eben eingeschriebene «Eins» wieder gelesen werden soll. Zu diesem Zwecke wird eine Spannung von 4 Volt vom Lesetreiber WP an den Emitter des Transistors 30 gelegt, während der Schreibtreiber WN auf 1,3 Volt liegt. Dadurch wird verursacht, dass der Speicherpunkt SN auf 3,2 Volt aufgeladen wird. Gleichzeitig beginnt die Bitleitung sich auf 1,2 Volt aufzuladen. Diese Änderung von 0,1 Volt auf den Bitleitungen wird durch den Leseverstärker BL abgefühlt und als «Eins» erkannt.

Da wie bereits gesagt, das Lesen der Zelle zerstörend ist, wird der Speicherpunkt auf 3,2 Volt aufgeladen, was bedeutet, dass effektiv eine «Null» in dieser Zelle gespeichert ist. Wegen der Ausbildung der Speicherzelle ist es nun erforderlich, dass immer auf einen Lesezyklus ein Schreibzyklus folgt. In diesem Fall wird beim Schreiben einer «Null» der Lesetreiber WP auf 0 Volt gehalten und der Schreibtreiber WN auf 0,1 Volt heruntergezogen. Da die Bitleitung auf 0,1 Volt durch den Bittreiber gehalten wird, wird verhindert, dass der NPN-Transistor 31 in den leitenden Zustand geht, wodurch keine Änderung im Zustand des Speicherpunktes SN auftritt, weil er vorher durch einen Lese-Eins-Zyklus auf 3,2 Volt aufgeladen wurde und dort verbleibt. Es ist nun erforderlich, dass die Bitleitung auf 0,1 Volt heruntergezogen wird, um sicherzustellen, dass der NPN-Transistor 31 nicht eingeschaltet wird, wodurch eine «Eins» versehentlich in diese Zelle eingeschrieben würde. Wenn der Impuls vom Schreibtreiber beendet ist, ist auch die Bitleitung wieder auf den normalen Spannungspegel von 1,1 Volt aufgeladen.

Um nun wiederum die gespeicherte «Null» zu lesen, wird der Lesetreiber WP auf 4 Volt hochgebracht. Da der Speicherpunkt SN voll aufgeladen ist, wird der Transistor 30 nicht eingeschaltet und keine Änderung des Zustands am Speicherpunkt SN oder im Zustand der Bitleitungen erfolgt, wodurch angezeigt wird, dass eine «Null» in der Speicherzelle eingespeichert ist.

**Patentansprüche**

1. Dynamisch betriebene Speicherzelle aus zwei komplementären bipolaren Transistoren (30, 31), und Kapazitäten (C1, C2, C3) zur Informationsspeicherung, die einmal zwischen dem Emitter und der Basis des PNP-Transistors (30), zum anderen zwischen der Basis und dem Kollektor des NPN-Transistors (31) sowie durch die kombinierte Kapazität (C3) der PN-Übergangskapazität (29) gebildet sind, zum Aufbau eines integrierten Halbleiterspeichers, dessen Speicherzellen in Kreuzungspunkten von Wort- und Bitleitungen auf einem Halbleitersubstrat (11) angeordnet sind, dadurch gekennzeichnet, dass die Speicherzelle (18) von jeder anderen im hochintegrierten Speicher befindlichen Speicherzelle durch sie voll umgebende und miteinander verbundene Gräben (34) isoliert ist, die oxidiert ausgeführt und mit Halbleitermaterial ausgefüllt sind um auf dem Substrat (11) ein Isolationsgitter (14) zu bilden.

2. Dynamisch betriebene Speicherzelle nach Anspruch 1, dadurch gekennzeichnet, dass die miteinander verbundenen Gräben (34) durch eine auf dem Substrat (11) aufgebrachte Epitaxialschicht (13) und eine PN-Grenzschicht (29) zwischen dem Substrat (11) und der genannten epitaxialen Schicht (13) hindurchreichen, und dass im Inneren der Gitterstruktur voneinander vollständig isolierte Speicherzelleninseln (13a bis 13i) aus epitaxialem Material angeordnet sind.

3. Dynamisch betriebene Speicherzelle nach den Ansprüchen 1 und 2, dadurch gekennzeichnet, dass die Wände der Gräben (34) mit einer dünnen Siliciumdioxidschicht (25) überzogen sind, dass der Boden der Gräben (34) gegebenenfalls von einer vorher aufgebrachten Siliciumdioxidschicht (25a) voll befreit ist und P-gedoptes Siliciummaterial in dem Graben (34) angeordnet ist, das mit dem darunterliegenden Substrat (11) verschmolzen ist.

4. Dynamisch betriebene Speicherzelle nach den Ansprüchen 1 bis 3, dadurch gekennzeichnet, dass in jeder epitaxialen Insel (13a, b, c, ...), unter der Subkollektoren (12, 12a, 12b) liegen, P-Regionen (15, 16) angeordnet sind, wobei die Region (15) einen PN-Übergang (26) mit der darunterliegenden epitaxialen Insel (13a) und die Region (16) damit einen PN-Übergang (27) bildet, dass in einer der P-Regionen (16) eine N-Diffusion (17) angeordnet ist, die zusammen einen PN-Übergang (28) bilden, dass das gesamte Halbleiterplättchen oberhalb des Isolationsgitters (14), der epitaxialen Inseln (13a, 13b, 13c) und der P-Regionen (15 und 16) mit einer isolierenden Schicht (30) überzogen ist, die Durchgangslöcher (19 bis 21) aufweist, um die darunterliegenden Regionen (15 bis 17) mit Metalleitern (22 bis 24) zu kontaktieren.

5. Dynamisch betriebene Speicherzelle nach den Ansprüchen 1 bis 4, dadurch gekennzeichnet, dass der PNP-Transistor (30) aus der Region (15), die als Emitter wirkt, aus der Region (16), die als Kollektor wirkt und dem Teil der nicht diffundierten Insel (13a) als Basis, der dazwischen liegt, besteht, dass der NPN-Transistor (31) durch die Region (17), die als Emitter dient, durch die Region (16), welche als Basis dient und durch die Insel (13a), die zusammen mit dem Subkollektor (12) als Kollektor dient, gebildet ist, dass eine erste Kapazität (C1), die zwischen dem Emitter und der Basis des PNP-Transistors (30) liegt, als Kapazität des PN-Übergangs (26) ausgebildet ist, dass eine zweite Kapazität (C2) zwischen der Basis und dem Kollektor des NPN-Transistors (31) durch die Kapazität des PN-Übergangs (27) gebildet ist und dass eine dritte Kapazität (C3) durch die kombinierte Kapazität der PN-Übergangskapazität (29) und eines Oxidüberzugs (25b), der die Inseln (13a) von Siliciumgitter (14) isoliert, gebildet wird und dass jede der genannten Kapazitäten (C1 bis C3) einen gemeinsamen Referenzpunkt (SN, z.B. Epitaxialinsel 13a) aufweist.

6. Dynamisch betriebene Speicherzelle nach den Ansprüchen 1 bis 5, dadurch gekennzeichnet, dass die beiden erstgenannten Kapazitäten (C1 und C2) im Verhältnis zur dritten Kapazität (C3) sehr klein sind und als Verarmungskapazitäten zwischen den gleichzeitig diffundierten P-Regionen (15 und 16) und einer epitaxialen Insel (13a) ausgebildet sind.

**Claims**

1. Dynamically operated memory cell consisting of two complementary bipolar transistors (30, 31) and capacitances (C1, C2, C3) for data storage which are formed, on the one hand, between the emitter and the base of the PNP transistor (30), and on the other between the base and the collector of the NPN transistor (31), as well as by the combined capacitance (C3) of the PN junction capacitance (29) in order to build an integrated semiconductor memory whose storage cells are arranged in the point of intersection of word and bit lines on a semiconductor substrate (11), characterized in that the storage cell (18) is isolated from any other storage cell in the highly integrated memory by interconnected trenches (34) which fully surround it and are oxidized and filled with semiconductor material in order to form an isolation grid (14) on the substrate (11).

2. Dynamically operated memory cell as claimed in claim 1, characterized in that the interconnected trenches (34) reach through an epitaxial layer (13) on the substrate (11) and a PN junction (29) between the substrate (11) and the above mentioned epitaxial layer (13), and that inside the grid structure memory cell islands (13a to 13i) completely isolated from each other and consisting of epitaxial material are arranged.

3. Dynamically operated memory cell as claimed in claims 1 and 2, characterized in that the walls of the trenches (34) are coated with a thin silicon dioxide layer (25), that a previously applied silicon dioxide layer (25a) is, if necessary, fully removed from the bottom of the trenches (34), and that P-doped silicon material is arranged in the trench (34) and fused with the substrate (11) therebeneath.

4. Dynamically operated memory cell as claimed in claims 1 to 3, characterized in that in each of the epitaxial islands (13a, b, c, ...) having subcollectors (12, 12a, 12b) therebeneath P regions (15, 16) are arranged, the region (15) forming a PN junction (26) with the epitaxial island (13a) therebeneath, and region (16) forming a PN junction (27) therewith, that in one of the P regions (16) an N diffusion (17) is provided, both elements together forming a PN junction (28), that the entire semiconductor chip is coated above the isolation grid (14), the epitaxial islands (13a, 13b, 13c) and the P regions (15 and 16) with an isolating layer (30) having through holes (19 to 21) for contacting the regions (15 to 17) therebeneath with metal conductors (22 to 24).

5. Dynamically operated memory cell as claimed in claims 1 to 4, characterized in that the PNP transistor (30) consists of region (15) acting as an emitter, of region (16) acting as a collector, and the interposed part of the non-diffused island (13a) as a basis, that the NPN transistor (31) is formed by the region (17) acting as an emitter, by region (16) acting as a base and by the island (13a) which together with the subcollector (12) acts as a collector, that a first capacitance (C1) between the emitter and the base of the PNP transistor (30) is designed as a capacitance of the PN junction (26), that a second capacitance (C2) between the base and the collector of the NPN transistor (31) is formed by the capacitance of the PN junction (27), and that a third capacitance (C3) is formed by the combined capacitance of the PN junction capacitance (29) and of an oxide coating (25b) which isolates the islands (13a) from the silicon grid (14), and that each of the above capacitances (C1 to C3) has a common point of reference (SN, e.g. epitaxial island 13a).

6. Dynamically operated memory cell as claimed in claims 1 to 5, characterized in that the two first-mentioned capacitances (C1 and C2) are very small compared with the third capacitance (C3) and are designed as depletion capacitances between the simultaneously diffused P regions (15 and 16) and an epitaxial island (13a).

**Revendications**

1. Cellule de mémoire à fonctionnement dynamique composée de deux transistors (30, 31) bijonction complémentaires et, pour la mémorisation d'informations, de capacités (C1, C2, C3) qui sont formées, d'une part, entre l'émetteur et la base du transistor PNP (30), d'autre part, entre la base et le collecteur du transistor NPN (31) ainsi que par la capacité combinée (C3) de la capacité de jonction PN (29), pour le montage d'une mémoire intégrée à semi-conducteurs dont les cellules sont disposées aux points d'intersection des fils de mots et de bits sur un substrat (11) à semi-conducteurs, caractérisée par le fait que la cellule de mémoire (18) est isolée de chaque autre cellule se trouvant dans la mémoire à haute intégration par des tranchées (34) l'entourant complètement et mutuellement raccordées qui sont réalisées oxydées et remplies de matériau semiconducteur pour former sur le substrat (11) une grille d'isolation (14).

2. Cellule de mémoire à fonctionnement dynamique selon la revendication 1, caractérisée par le fait que les tranchées (34) mutuellement raccordées s'étendent à travers et couche épitaxiale (13) appliquée sur le substrat (11) et une couche de jonction PN (29) entre le substrat (11) et la couche épitaxique (13) précitée, et qu'à l'intérieur de la structure de grille sont disposés des îlots (13a à 13i) de la cellule de mémoire en matériau épitaxial complètement isolés les uns des autres.

3. Cellule de mémoire à fonctionnement dynamique selon les revendications 1 et 2, caractérisée par le fait que les parois des tranchées (34) sont revêtues d'une mince couche (25) de dioxyde de silicium, que le fond des tranchées (34) est éventuellement complètement débarrassé d'une couche (25a) de dioxyde de silicium préalablement appliquée et que dans la tranchée (34) est introduit du matériau en silicium dopé P qui est fusionné avec le substrat (11) sous-jacent.

4. Cellule de mémoire à fonctionnement dynamique selon les revendications 1 à 3, caractérisée par le fait que dans chaque îlot épitaxial (13a, b, c, ...) sous lequel se trouvent des sous-collecteurs (12, 12a, 12b) sont disposées des régions P (15, 16), la région (15) formant une jonction PN (26) avec l'îlot épitaxial sous-jacent (13a) et la région (16) formant avec celui-ci une jonction PN (27), que dans l'une des régions P (16) est disposée une diffusion N (17) qui forment ensemble une jonction PN (28), que la totalité de la plaquette à semiconducteurs au-dessus de la grille d'isolation (14), des îlots épitaxiaux (13a, 13b, 13c) et des régions P (15 et 16) est recouverte d'une couche isolante (30) qui comporte des trous de passage (19 à 21) pour établir le contact avec les régions sous-jacentes (15 à 17) au moyen de conducteurs métalliques (22 à 24).

5. Cellule de mémoire à fonctionnement dynamique selon les revendications 1 à 4, caractérisée par le fait que le transistor PNP (30) se compose de la région (15) qui fait office d'émetteur, de la région (16) qui fait office de collecteur et de la partie de l'îlot non diffusé (13a) servant de base et placé au milieu, que le transistor NPN (31) est formé par la région (17) qui sert d'émetteur, par la région (16) qui sert de base et par l'îlot (13a) qui, en liaison avec le sous-collecteur (12), sert de collecteur, qu'une première capacité (C1), qui est placée entre l'émetteur et la base du transistor PNP (30), est réalisée sous la forme de capacité de la jonction PN (26), qu'une deuxième capacité (C2) entre la base et le collecteur du transistor NPN (31) est formée par la capacité de la jonction PN (27), et qu'une troisième capacité (C3) est formée par la capacité combinée de la capacité de jonction PN (29) et d'un revêtement oxyde (25b) qui isole les îlots (13a) de la grille de silicium (14), et que chacune des capacités précitées (C1 à C3) a un point de référence commun (SN, par exemple îlot épitaxial 13a).

6. Cellule de mémoire à fonctionnement dynamique selon les revendications 1 à 5, caractérisée par le fait que les deux capacités (C1 et C2) les premières citées sont très petites par rapport à la troisième capacité (C3) et sont réalisées en tant que capacités de dépletion entre les régions P (15 et 16) diffusées en même temps et un îlot épitaxial (13a).

FIG. 1

FIG. 2

FIG. 3

FIG. 4

FIG. 5

FIG. 6

FIG. 7

FIG. 8

FIG. 9